# EUROPEAN PATENT APPLICATION

(11) **EP 4 818 690 A1**
(43) Date of publication of application: **07.10.2026**
(21) Application number: 25167237.4
(22) Date of filing: 31.03.2025
(51) Int. Cl.: G01N 27/22

(54) **OSCILLATOR BASED CAPACITANCE SENSING OF ELECTRODES FOR ELECTROWETTING ON DIELECTIC APPLICATIONS**

(71) Applicant: Imec VZW, 3001 Leuven (BE)
(72) Inventor: Velazquez Lopez, Mauricio, 3000 Leuven (BE); Myny, Kris, 3550 Heusden-Zolder (BE); Papadopoulos, Nikolaos, 3010 Leuven (BE)
(74) Representative: Roth, Sebastian

(57) **Abstract**

This disclosure relates to droplet manipulation and sensing of a capacitive value of an electrode element used for the droplet manipulation. To this end, the disclosure presents an input-controlled oscillator circuit connectable to the electrode element. A node of the oscillator circuit is connectable to the electrode element. The oscillator circuit comprises an input stage connected to the node for providing a current or current pulse for charging an electrode of an electrode pair of the electrode element based on a control input. The oscillator circuit also comprises an oscillator core circuit connected to the node for cyclically discharging the electrode of the electrode element, to generate an oscillation with a frequency depending on the electrode element capacitance. The oscillator core circuit produces a voltage signal at an output node, which is based on a capacitance value of the electrode element and on the control input shifting the oscillation frequency.

## Description

### TECHNICAL FIELD

The present disclosure relates to droplet manipulation. In particular, the disclosure is concerned with the sensing of a capacitive value of an electrode element usable for the droplet manipulation. To this end, the disclosure presents an input-controlled oscillator circuit, which is connectable to the electrode element, and presents an electrowetting on dielectric (EWOD) array that comprises multiple electrode elements connected to at least one input-controlled oscillator circuit.

### BACKGROUND

Electrowetting is a phenomenon where an electric field modifies the wettability of a liquid on a surface. This effect is used in digital microfluidics, particularly in EWOD arrays, which enable precise manipulation of small liquid droplets on a grid of electrodes covered by a dielectric layer. By applying controlled voltages, the droplets can be manipulated, for instance, can be moved, merged, split, or mixed. This makes EWOD arrays valuable for lab-on-chip applications, biomedical assays, or electronic displays.

Silicon CMOS solutions exist for fabricating EWOD arrays, but also thin-film transistor (TFT) technology is an excellent option for designing and fabricating EWOD arrays with high electrode count. The reasons for the popularity of TFT technology are its ability to cover large areas at low cost, and the possibility to employ flat panel display techniques such as active matrix (AM) addressing. The latter may significantly increase the number of individually addressable electrodes. Although AM digital microfluidics systems have been demonstrated in both CMOS and TFT technology, little attention has been paid to additional functions other than the droplet manipulation. One example of an additional function is the accurate sensing of the capacitance value of an electrode element of the EWOD array, which can provide useful information such as the detection of droplets and a possible distinction in the fluid composition of the droplets.

### SUMMARY

Therefore, this disclosure has the objective to provide a solution for sensing a capacitance value of an electrode element that is suitable for electrowetting, particularly, an electrode element of an EWOD array. An objective thereby is to enable the implementation of functions that are beneficial for lab-on-chip applications. For example, these functions may comprise, in an EWOD array, checking for malfunction of electrode elements, droplet position detection, estimation of the droplet volume, or distinguishing different fluid compositions.

Another objective is to provide a solution that can be used for large area arrays. The solution should moreover be simple, compact, and usable as close to the electrode element(s) as possible.

These and other objectives are achieved by the solutions of this disclosure, which are described in the independent claims. Advantageous implementations are described in the dependent claims.

A first aspect of this disclosure provides an input-controlled oscillator circuit for sensing a capacitance of an electrode element, the electrode element being suitable for an EWOD array for droplet manipulation, wherein the electrode element comprises a pair of electrodes, and a node of the input-controlled oscillator is connectable to a first electrode of the electrode pair; and wherein the input-controlled oscillator circuit comprises: an input stage connected to the node, and configured to provide a current or current pulse for charging the first electrode based on a received control input; an oscillator core circuit connected to the node, and configured to cyclically discharge the first electrode, thereby generating an oscillation with an oscillation frequency that depends on the capacitance of the electrode element; wherein the oscillator core circuit is further configured to produce a voltage signal at an output node of the oscillator core circuit, based on a capacitance value of the electrode element and the control input shifting the oscillation frequency.

The input-controlled oscillator circuit may be controlled either by a voltage or by a current as the control input. Accordingly, the input-controlled oscillator circuit may be a voltage-controlled oscillator (VCO) circuit or a current-controlled oscillator (CCO) circuit.

The oscillator core circuit is configured to generate the output voltage signal in response to the capacitance value and the control input used to control the input-controlled oscillator circuit. For example, in case of a VCO circuit, the output voltage signal depends on the capacitance value and the voltage used to control the VCO circuit. This is similar in a CCO circuit. The output voltage signal may comprise a frequency of an oscillating voltage, or a voltage slope, or a voltage spike.

The input-controlled oscillator circuit of the first aspect allows accurate sensing of the capacitance value of the electrode element. This allows further determining, for instance, the presence of a droplet between the electrode element, a droplet position with respect to the electrode element, a droplet volume, a composition of the liquid making up the droplet, or a malfunction of the electrode element.

The input-controlled oscillator circuit of the first aspect can be built compact and simple - e.g. it may use only a few transistors and/or resistors - and can be integrated well with an EWOD array, in particular, close to the electrode element.

In an implementation of the input-controlled oscillator circuit, the voltage signal at the output node is a voltage spike indicative of the capacitance value of the electrode element.

In particular, the voltage signal at the output node of the oscillator core circuit may comprises a sequence of voltage spikes, and a frequency thereof (i.e., a time between two consecutive spikes) is indicative of the capacitive value of the electrode element. The voltage spikes may occur when a (sudden) capacitance change disrupts the oscillator circuits charge/discharge cycle, causing transient energy redistribution. Thus, a change in the time between two consecutive voltage spikes in the sequence of voltage spikes may depend on the capacitance value and/or a change thereof.

In an implementation of the input-controlled oscillator circuit, the capacitance value of the electrode element is caused by the appearance or disappearance of a droplet between the electrode pair or by a change in the nature of liquid between the electrode pair.

The capacitance value of the electrode element changes obviously in dependence on the dielectric between the electrodes, i.e., is different for air (not droplet) and liquid (droplet). The capacitance value may also be caused by a change in the nature of the liquid (e.g. when mixing reagents), or a change of a volume of the droplet or liquid. A volume of the droplet may be extrapolated from the measurements as well.

In an implementation of the input-controlled oscillator circuit, the input stage comprises a first transistor; the first transistor being arranged to receive the control input at a first source/drain, SD, terminal, and to provide the current pulse from a second SD terminal, which is connected to the node and to a gate terminal of the transistor.

This may provide a continuous current for charging the electrode element.

In an implementation of the input-controlled oscillator circuit, the oscillator circuit further comprises a second transistor connected between the node and the reference voltage, and connected with its gate terminal to the output node of the oscillator core circuit.

In an implementation of the input-controlled oscillator circuit, the oscillator circuit further comprises a switch arranged between the gate terminal of the second transistor and the output node of the oscillator core circuit; wherein the switch is configured to selectively disconnect the gate terminal of the second transistor from the output node of the oscillator circuit.

The switch may be beneficial for reducing the power consumption of the oscillator circuit.

In an implementation of the input-controlled oscillator circuit, the input stage comprises a resistor connected to a first SD terminal of a first transistor; the resistor being arranged to receive the control input; and the first transistor being arranged to provide the current pulse via its second SD terminal, which is connected to the node, in response to a varying voltage provided to a gate terminal of the first transistor.

This may provide a discrete current (pulsed). The one transistor and one resistor (1T1R) input stage may be beneficial for reducing the size of the oscillator circuit.

In an implementation of the input-controlled oscillator circuit, the input-controlled oscillator circuit further comprises a buffer circuit connected between the node and the oscillator core circuit.

The buffer circuit may be implemented as a source follower TFT, however, this is just an example. The buffer circuit may reduce the influence of parasitic elements in the oscillator circuit.

In an implementation of the input-controlled oscillator circuit, the oscillator core circuit comprises two or more consecutively connected oscillation stages, the connected oscillation stages forming an oscillator.

The oscillator stages may not oscillate individually, however, due to their connection to each other.

In an implementation of the input-controlled oscillator circuit, each oscillator stage comprises a transistor pair; the two transistors of the transistor pair being connected in series between a supply voltage and the reference voltage; and gate terminals of the two transistors being connected together and connected to either the node or to the transistor pair of the previous oscillator stage.

In an implementation of the input-controlled oscillator circuit, the oscillator core circuit further comprises: one or more power gating transistors connecting, respectively, one or more of the oscillation stages to a supply voltage; or one or more clock gating transistors, each clock gating transistor being connected between two consecutive oscillation stages or between the oscillator core circuit and the node.

The power gating and clock gating may be beneficial to reduce the power consumption of the oscillator circuit.

In an implementation of the input-controlled oscillator circuit, the input-controlled oscillator circuit further comprises an analog output stage connected to the output node of the oscillator core circuit; wherein the analog output stage is configured to convert the voltage signal at the output node into a voltage discharge or charge signal; a slope or an absolute value of the voltage discharge or charge signal being indicative of the capacitance of the electrode element.

In an implementation of the input-controlled oscillator circuit, the input-controlled oscillator circuit further comprises a digital counter connected to the output node of the oscillator core circuit; wherein the digital counter is configured to count a number of voltage signals per predetermined time period at the output node, and to output a digital word based on the counted number, which is indicative of the capacitance of the electrode element.

This realizes a digital output stage. For instance, the number of spikes per second may be translated into the digital word.

A second aspect of this disclosure provides an EWOD array for a microfluidics system, the EWOD array being configured to manipulate one or more droplets by electrowetting and comprising: a plurality of pixels, each pixel comprising an electrode element; one or more input-controlled oscillator circuits respectively according to the first aspect or any implementation thereof, wherein each input-controlled oscillator circuit is connected to an electrode element of at least one pixel.

The input-controlled oscillator circuit(s) may sense droplets in the EWOD array. The EWOD array may comprise additional circuitry, for instance, TFTs, which are used to drive the pixels, which is what may causes the droplets manipulation. The TFTs may control electric fields to modulate surface tension, enabling precise droplet manipulation by electrostatic actuation. Each pixel may be connected to an individual input-controlled oscillator circuit.

In an implementation of the EWOD array, the EWOD array is configured to, based on an output of the VCO circuit, determine at least one of: a capacitance or a capacitance change of the electrode element, in dependence of a presence or not of a droplet between the electrode pair; a position of the droplet between the electrode pair; a volume of the droplet between the electrode pair; a liquid composition of the droplet between the electrode pair; a malfunction of the electrode element.

The EWOD array of the second aspect may have implementations that correspond to (i.e., include) the implementations of the input-controlled oscillator circuit of the first aspect. The EWOD array of the second aspect enjoys all advantages described above with respect to the input-controlled oscillator circuit of the first aspect.

In summary of the above aspects and implementations, a simple (e.g., only 6 elements like transistor and/or resistors) oscillator-based capacitance sensing circuit is provided by this disclosure, suitable for large area EWOD arrays. The input-controlled oscillator circuit may be small in size, hence, well implementable in-electrode/in-pixel of the EWOD array. The oscillator circuit is further scalable to large area arrays. The output of the oscillator circuit can be transformed into an analog or a digital output for easy readout.

### BRIEF DESCRIPTION OF THE DRAWINGS

The above described aspects and implementations are explained in the following description of embodiments with respect to the enclosed drawings:
- FIG. 1: shows an input-controlled oscillator circuit according to this disclosure.
- FIG. 2: shows an exemplary top-level block diagram of an input-controlled oscillator circuit according to this disclosure, which is connected to an electrode element of an EWOD array.
- FIG. 3: shows various exemplary implementations of the input stage of the input-controlled oscillator circuit of this disclosure.
- FIG. 4: shows various exemplary implementations of the oscillator core circuit of the input-controlled oscillator circuit, either with or without output stage.
- FIG. 5: shows further exemplary implementations of the oscillator core circuit of the input-controlled oscillator circuit of this disclosure, including additional transistors.
- FIG. 6: shows various exemplary implementations of the optional output stage of the input-controlled oscillator circuit of this disclosure.
- FIG. 7: shows a specific exemplary implementation of the input-controlled oscillator circuit of this disclosure.
- FIG. 8: shows an EWOD array, which includes an input-controlled oscillator circuit according to this disclosure.
- FIG. 9: illustrates a multiplexing example for an EWOD array with multiple electrodes and an input-controlled oscillator circuit according to this disclosure comprising one input stage.
- FIG. 10: illustrates a multiplexing example for an EWOD array with multiple electrodes and an input-controlled oscillator circuit according to this disclosure comprising multiple input stages.
- FIG. 11: illustrates a multiplexing example for an EWOD array with multiple electrodes and an input-controlled oscillator circuit according to this disclosure comprising one input stage.
- FIG. 12: illustrates a multiplexing example for an EWOD array with multiple electrodes and an input-controlled oscillator circuit according to this disclosure comprising multiple input stages.

Same elements in the figures are labelled with the same reference signs, and may be implemented likewise, even if they are not redundantly described.

### DETAILED DESCRIPTION OF EMBODIMENTS

Illustrative embodiments of an input-controlled oscillator circuit 10 according to this disclosure and its constituting components (e.g., circuits) are described with reference to the figures in the following. Although this description provides detailed implementations, it should be noted that the details are exemplary and in no way limiting to the scope of this disclosure.

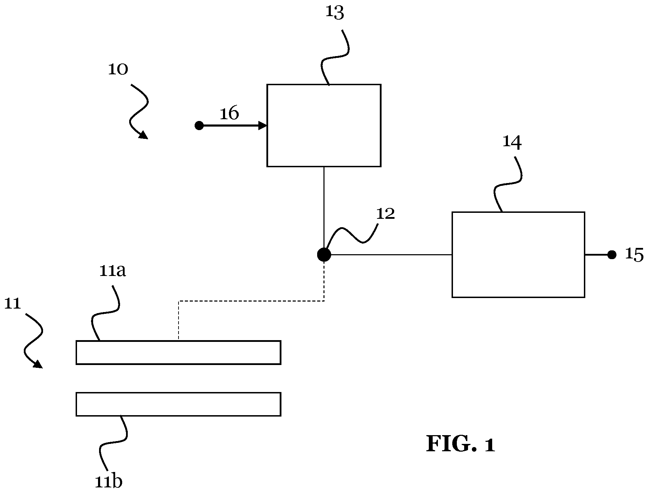

FIG. 1 shows a schematic of the input-controlled oscillator circuit 10. The input-controlled oscillator circuit 10 is usable for an EWOD array, for instance, may be integrated into an EWOD array. In particular, the oscillator circuit 10 is configured to be used for sensing a capacitance of an electrode element 11 of the EWOD array. The electrode element 11 is suitable for droplet manipulation in the EWOD array.

The electrode element 11 comprises a pair of electrodes, i.e. a first electrode 11a and a second electrode 11b. The two electrodes 11a, 11b may respectively comprise a conductive layer (e.g., made of a metal like indium tin oxide and/or gold), which is covered by a dielectric layer and a hydrophobic coating. The electrode element 11 and its two electrodes 11a, 11b can be implemented as in a known EWOD array. A space between the two electrodes 11a, 11b may be left empty (i.e., it may comprise only air), or may be filled with a liquid like a silicone oil.

The input-controlled oscillator circuit 10 further comprises a node 12, which is connectable to the first electrode 11a of the electrode pair 11. In an EWOD array comprising the oscillator circuit 10, the node 12 is connected to the first electrode 11a of one electrode element 11 or respective first electrodes 11a of multiple electrode elements 11.

The input-controlled oscillator circuit 10 further comprises an input stage 13, an oscillator core circuit 14, and optionally an output stage described later.

The input stage 13 is connected to the node 12, and is configured to provide a current or current pulse (or current package) for charging the first electrode 11a of the electrode element 11. The current or current pulse is provided based on, e.g. in accordance with, a received control input 16. The control input 16 may be a control voltage (in case of a VCO circuit 10) or a control current (in case of a CCO circuit 10).

The oscillator core circuit 14 is connected to the node 12 as well, and is configured to cyclically discharge the first electrode 11a. The cyclic discharging leads to the oscillator core circuit 14 generating an oscillation having an oscillation frequency. The oscillation frequency depends on the capacitance of the electrode element 11, particularly changes with the change of a capacitance value of the electrode element 11. The oscillator core circuit 14 is further configured to produce a voltage signal at an output node 15, wherein the voltage signal is based on the capacitance value of the electrode element 11 and on the control input 16 provided to the input stage 13, since the control input 16 shifts the oscillation frequency. For instance, a frequency of the voltage signal, or a frequency of voltages spikes in the voltage signal, may be based on the capacitance value of the electrode element 11.

Using the input-controlled oscillator circuit 10, the capacitance value of the electrode element 11, e.g. in the EWOD array, may be accurately measured, and also changes in the capacitance value may be detected timely. Notably, the capacitance value and the changes of the capacitance value may depend on several parameters. For instance, an area of the electrodes 11a, 11b of the electrode element 11 (capacitance increase with area increase), the distance between the electrodes 11a, 11b (capacitance decrease with distance increase), and the permittivity of the liquid of the droplet (capacitance increase with permittivity increase).

Of further note, in many EWOD arrays, one electrode 11b of the electrode element 11 is connected to the reference voltage or is grounded. Generally, ground may be the reference voltage in this disclosure, but the reference voltage may also be different from ground. If the reference voltage is different from ground, it may have a different or opposite polarity (e.g., positive or negative) than the polarity (e.g., negative or positive) of the charged first electrode 11a, but not necessarily. Alternatively, the reference voltage may also have the same polarity as the charged first electrode 11a (both being positive or negative), e.g. a value between zero and the value of the charged first electrode 11a.

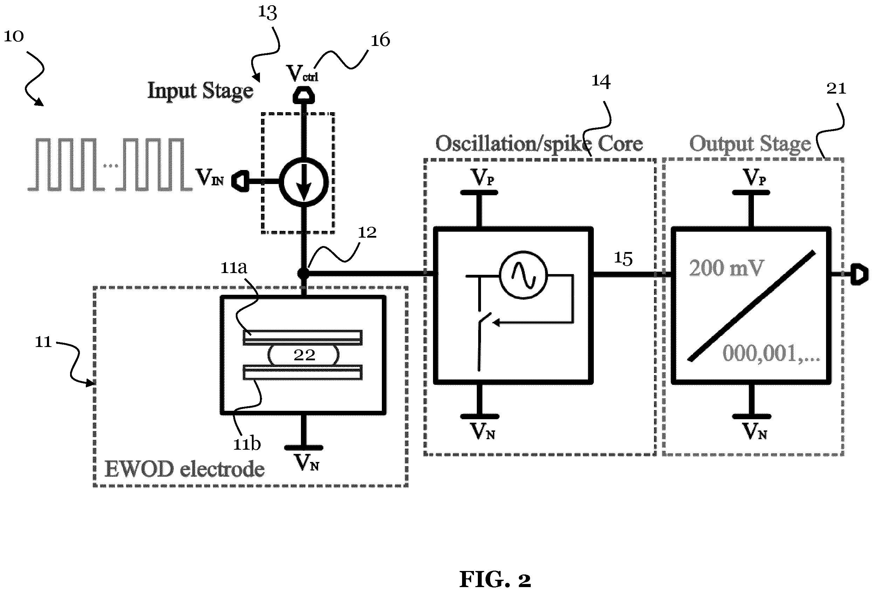

FIG. 2 shows an exemplary top-level block diagram of the input-controlled oscillator circuit 10 according to this disclosure, building on FIG. 1. The oscillator circuit 10 is connected to an EWOD electrode element 11.

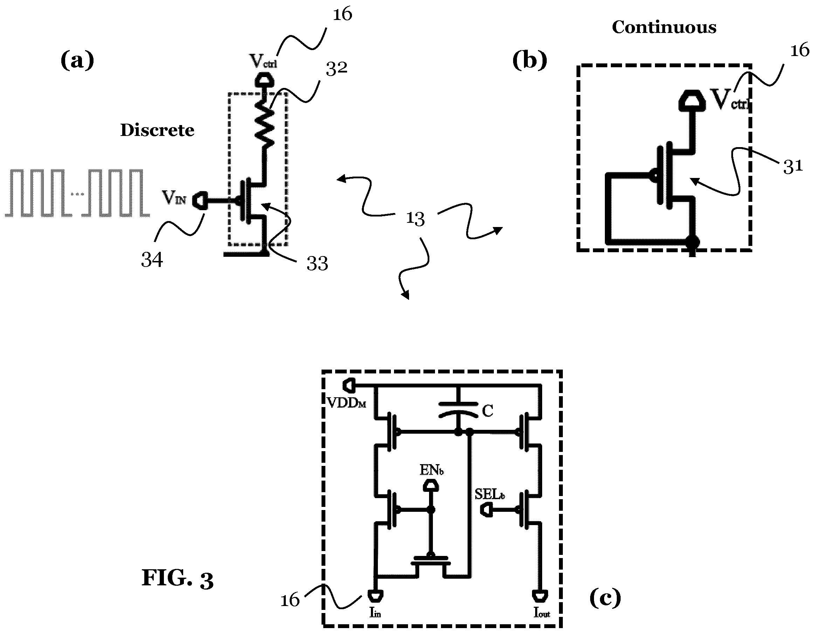

The input stage 13, as it is exemplarily illustrated, may be configured to provide the current or current pulse based on the control input 16 (in this example a control voltage V_{ctrl}) and in response to a varying voltage (the input voltage V_{IN}) provided to the input stage 13. As will be shown in FIG. 3, however, the input stage 13 can also be implemented in a different way.

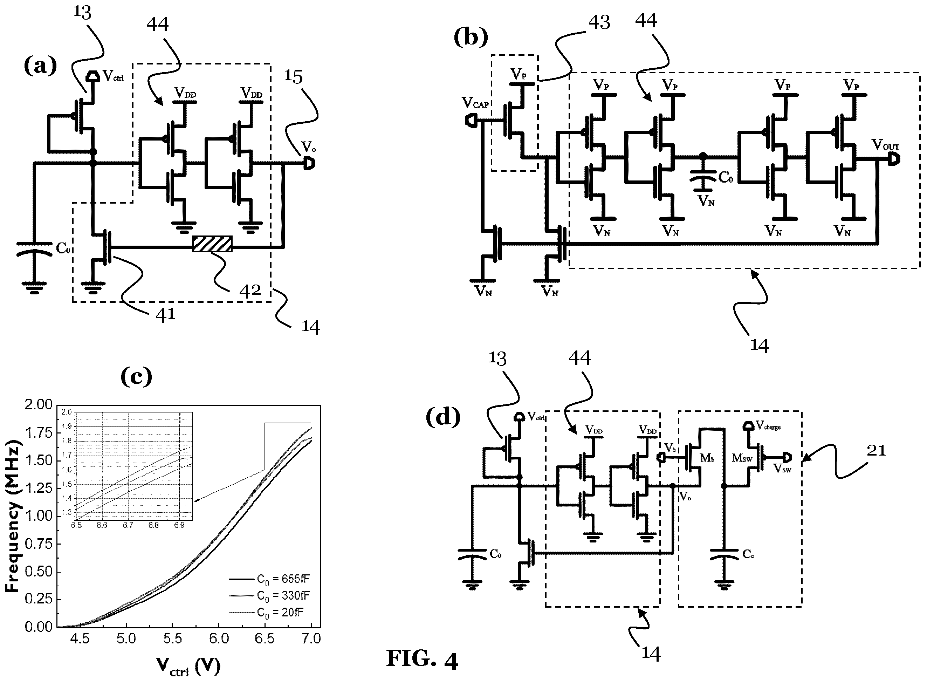

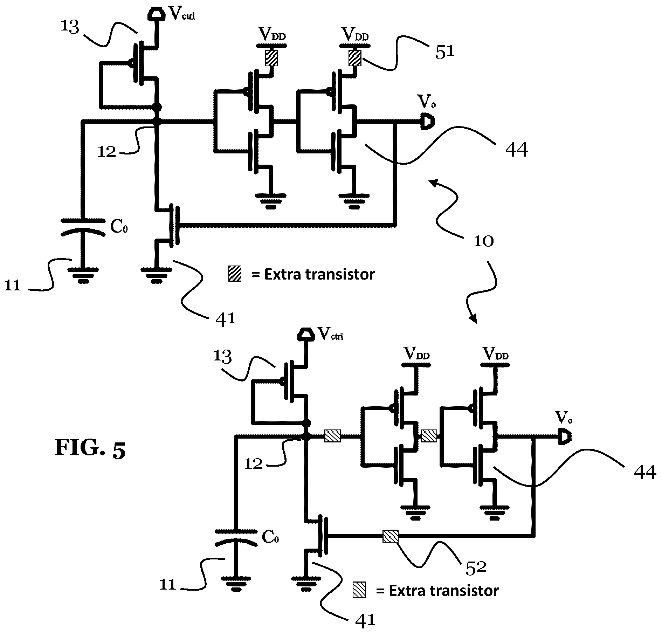

As also illustrated in FIG. 2, the voltage signal at the output node 15 of the oscillator core circuit 14 may comprises a sequence of voltage spikes, a frequency of which is indicative of the capacitance value of the electrode element 11. The oscillator core circuit 14 is connected between a supply voltage V_{P} and the reference voltage V_{N}, which may be ground. Different implementations of the oscillator core circuit 14 are possible, as will be shown in FIG. 4 and 5, respectively.

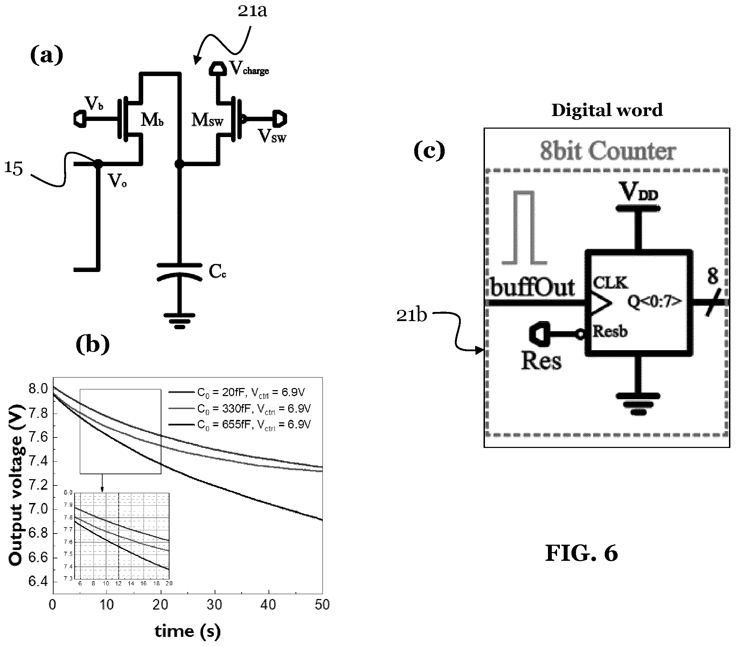

The input-controlled oscillator circuit 10 may further comprise an output stage 21 connected to the output node 15 of the oscillator core circuit 14. Various implementations are possible for the output stage 21, for example, analog or digital, as will be shown in FIG. 6. The output stage 21 may be configured to translate the voltage signal at the output node 15, for instance, into an analog voltage charge or discharge signal, or into a digital signal or word. The output stage 21 may be connected between V_{P} and V_{N} as well. Alternatively, the output stage 21 may be connected to some other supply voltages, provided there is the necessary level shifting, for example, provided as a circuit block. This disclosure is not limited in this regard, and the circuit designer may choose any suitable technology.

FIG. 3 shows various exemplary implementations of the input stage 13 of the input-controlled oscillator circuit 10 of this disclosure. For all input stages 13, the control input 16 is used to control the oscillation frequency of the oscillator core circuit 14, and thus the output voltage, e.g. the frequency of the voltage spike.

FIG. 3(a) shows a first implementation of the input stage 13, which comprises a resistor 32 and a transistor 33. The resistor 32 is connected between a node for receiving the input control 16 and a first source-drain (SD) terminal of the transistor 33. The resistor 32 is accordingly arranged to receive the control input 16, in this case the control voltage V_{ctrl}. The transistor 33 is arranged to provide a current pulse via its second SD terminal, which is connected to the node 12. The current pulse is provided in response to a varying voltage 34 V_{IN}, which is provided to a gate terminal of the transistor 33. A discrete current is accordingly provided by this input stage 13.

FIG. 3(b) shows a second implementation of the input stage 13, which comprises a transistor 31, which is arranged to receive the control input 16 at a first SD terminal, and to provide the current from a second SD terminal. The second SD terminal is connected to the node 12 and to a gate terminal of the transistor 31. The current may be provided continuously by this input stage 13.

FIG. 3(c) shows a third implementation of the input stage 13, which may provide discrete current pulses and continuous current. In particular, FIG. 3(c) shows a current mirror circuit. An input current Iᵢₙ goes into the left branch, and is copied into the right branch. In the right branch the signal SEL_{b} helps to turn on and off the full branch. If SEL_{b} is always ON (oV), then Iᵢₙ is copied continuously and the output current Iₒᵤₜ is also a continuous current. If SEL_{b} is a square wave going on and off (e.g., oV to VDD_{M}), then the branch also turns on and off, thereby creating the ouput current Iₒᵤₜ with current pulses. The singal En_{b} serves to completely turn off the current mirror to reduce power consumption. The current may be provided either continuously with this input stage 13 (SEL_{b} always ON), or a discrete current may be provided by this input stage 13 (SEL_{b} is turned ON and OFF, e.g., as a square wave).

FIG. 4 shows various exemplary implementations of the oscillator core circuit 14 of the input-controlled oscillator circuit 10, either with or without output stage 21. The oscillator core circuit 14 is used to generate the voltage signal, for instance, voltage pulses and/or voltage spikes with a frequency that is proportional to the capacitance value of the electrode element 11, as derivable from the graph shown in FIG. 4(c). The graph shows a dependence of the frequency on the capacitance and on the control input (control voltage V_{ctrl}).

FIG. 4(a) shows a first implementation of the oscillator core circuit 14. The oscillator core circuit 14 comprises two or more consecutively connected oscillation stages 44, wherein the connected oscillation stages 44 form an oscillator. Each oscillator stage 44 comprises a transistor pair. The two transistors of the transistor pair are connected in series between a supply voltage V_{DD} and the reference voltage (ground in this example). The gate terminals of the two transistors are connected together, and are connected to either the node 12 (for the left transistor pair in this illustrated case) or to the transistor pair of the previous oscillator stage 44 (for the right transistor pair in this illustrated case).

Optionally, the oscillator core circuit 44 of FIG. 4(a) further comprises a switch 42 arranged between the gate terminal of the second transistor 41 and the output node 15 of the oscillator core circuit 14. The switch 42 is configured to selectively disconnect (or connect) the gate terminal of the second transistor 41 from the output node 15 of the oscillator circuit 14, which is beneficial for the power consumption. In an exemplary implementation, the switch 42 may be a transistor, but it may also be implemented in a different way.

FIG. 4(b) shows a second implementation of the oscillator core circuit 14. The oscillator core circuit 14 is similar to the one shown of FIG. 4(a), although exemplarily it comprises more than two oscillation sages 44. However, in FIG. 4(b) the input-controlled oscillator circuit 10 comprises additionally a buffer circuit 43, which is connected between the node 12 and the oscillator core circuit 14. The buffer circuit 43 arranged before the oscillator stages 44 of the oscillator core circuit 14 can help to minimize the influence of parasitic elements.

FIG. 4(c) shows that the input-controlled oscillator circuit 10 may further comprise an output stage 21. The output stage 21a is connected to the output node 15 of the oscillator core circuit 14 (the one of FIG. 4(a) is shown as example, but it could likewise be the one of FIG. 4(b) or any other suitable oscillator core circuit 14).

FIG. 4 also shows that the input-controlled oscillator circuit 10 may further comprise a second transistor 41, which is connected between the node 12 and the reference voltage (e.g., to ground in this case), and is connected with its gate terminal to the output node 15 of the oscillator core circuit 14. The second transistor 41 may be considered being part of the oscillator core circuit 14, as indicated.

Once a voltage spike and/or current pulse has been created by the oscillator core circuit 14, the oscillator core circuit 14 is further designed to reset the first electrode 11a of the electrode element (by shorting its terminals e.g.) to start the charge cycle again.

Notably, any oscillator core circuit 14 of this disclosure may be shared and/or multiplexed among several electrode elements 11, as will be explained later.

FIG. 5 shows further exemplary implementations of the oscillator core circuit 14 of the input-controlled oscillator circuit 10, including additional transistors.

FIG. 5(a) shows an implementation of the oscillator core circuit 14, which comprises one or more power gating transistors 51. The power gating transistors 51 respectively connect one or more of the oscillation stages 44 to a supply voltage V_{DD}. The power gating transistors 51 help to reduce the power consumption of the input-controlled oscillator circuit 10.

FIG. 5(b) shows an implementation of the oscillator core circuit 14, which comprises one or more clock gating transistors 52. Each clock gating transistor 52 may be connected between two consecutive oscillation stages 44 or between the oscillator core circuit 14 and the node 12. Additionally or alternatively, a clock gating transistor 52 may also be connected between the output 15 of the oscillator core circuit and the second transistor 41, and may implement the switch 42 shown in FIG. 4, i.e., in this case the switch 42 would be a clock gating transistor 52.. The clock gating transistors 52 help to reduce the power consumption of the input-controlled oscillator circuit 10.

The power gating transistors 51 or the clock gating transistors 52 may be used in all or only some of the illustrated locations. That is, not every oscillation stage 44 may be connected via a power gating transistor 51 to the supply voltage, but only one or some of the oscillation stages 44. Likewise, not every two oscillation stages 44 may be connected by a clock gating transistor 52, but only two or several of them. The clock gating transistor 52, which implements the switch 42 previously shown in FIG. 4, is optional. The power gating transistors 51 may be used to interrupt power supply to the oscillator core circuit 14. The clock gating transistors 52 may be used to cut a loop of the oscillator core circuit 14.

FIG. 6 shows various exemplary implementations of an output stage 21 of the input-controlled oscillator circuit 10. The output stage 21 is used to extract information on the capacitance value of the electrode element 11. The output stage 21 can be analog or digital.

FIG. 6(a) shows an analog implementation 21a of the output stage 21, which is connected to the output node 15 of the oscillator core circuit 14. The analog output stage 21a is configured to convert the voltage signal generated at the output node 15 (e.g., voltage spike) into a voltage discharge or voltage charge signal, as shown in FIG. 6(b). A slope or an absolute value of the voltage discharge or charge signal being indicative of the capacitance of the electrode element 11. FIG. 6(b) shows a dependence of the converted output voltage (slope) on time and capacitance value of the electrode element 11.

FIG. 6(c) shows a digital implementation 21b of the output stage 21. The digital output stage 21b is a digital counter, which is connected to the output node 15 of the oscillator core circuit 14. The digital counter 21b is configured to count a number of voltage signals per predetermined time period at the output node 15, and to output a digital word based on the counted number, The digital word is indicative of the capacitance of the electrode element 11.

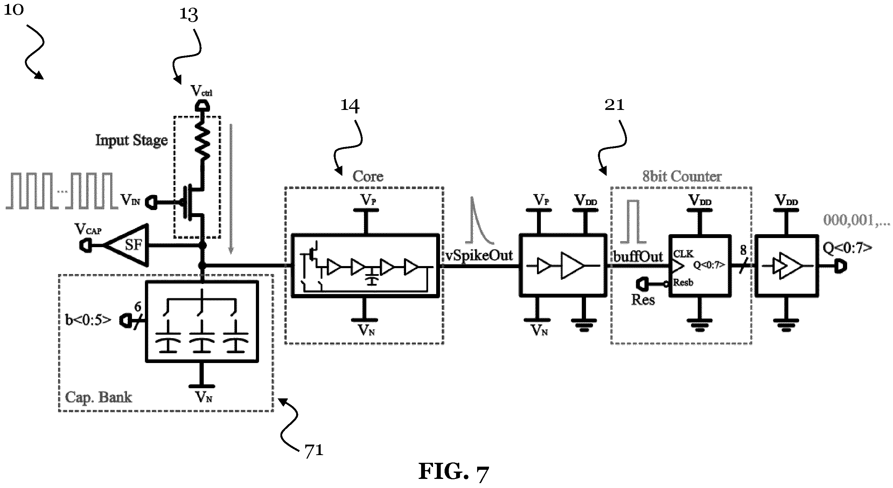

FIG. 7 shows a specific exemplary implementation of the input-controlled oscillator circuit 10, which is connected to a capacitive bank 71, which may be a test bank resembling an array of electrode elements 11 or may be an array of electrode elements 11.

The exemplary implementation comprises the input stage 13 of FIG. 3(a), the oscillator core circuit 14 of FIG. 4(b), and the digital output stage 21 of FIG. 6(c). The implementation of the oscillator circuit 10 comprises additional circuitry between the oscillator core circuit 14 (a buffer) and after the output stage 21 to process the digital word.

In Fig 7, the block named SF is source follower (particularly a large one), which is used as buffer to monitor the voltage at the node 12. It is optional for testing, and is not necessary for the oscillator circuit 10 to function.

The additional block between the oscillator core circuit 14 and the output stage 21 is a buffer and/or level shifter stage. This block may be used to make the output voltage pulses more consistent in amplitude and pulse width. This block may also generate voltage shifts in the voltage pulse amplitude from Vn-Vp to oV-Vdd. In this particular case Vn < oV < Vp < Vdd. The voltage shift may be used to make sure that the digital counter properly counts the pulses. The counter works between oV and Vdd.

The block at the very end of the chain, after the digital output stage 21, is a set of large digital buffers. These buffers may be used to make sure that measurement tools to test the circuit can be used. These digital buffers can drive heavier loads than the counter alone. This block may not be needed in a real case scenario, because in this case the digital word may be received by another circuit block (either TFT or CMOS) to do the post-processing. The digital buffers can be included in the digital output stage 21, as they depend on the post-processing and hence may or may not be needed depending on the use case.

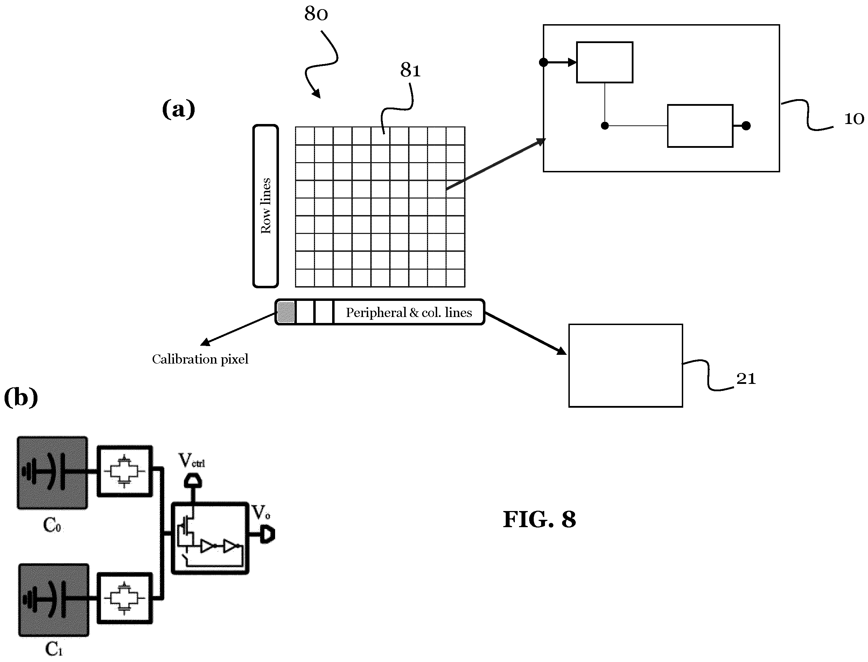

FIG. 8(a) shows an EWOD array 80 according to this disclosure, which includes at least one input-controlled oscillator circuit 10. The EWOD array 80 is suitable for a digital microfluidics system.

The EWOD array 80 is configured to manipulate one or more droplets by electrowetting. The EWOD array 80 comprises a plurality of pixels 81, wherein each pixel 81 comprising an electrode element 11. Each pixel 81 may be configured to sense and optionally manipulate a droplet arranged in between the electrodes 11a, 11b, of the electrode element 11. The array 80 further comprises the at least one input-controlled oscillator circuit 10. Each input-controlled oscillator circuit 10 can be connected to the electrode element 11 of just one pixel 81, or may be connected to multiple electrode elements 11 of multiple pixels 81.

The input stage 13 and oscillator core circuit 14 may be located close to the electrode elements 11, for instance, integrated into or below the pixel 81. The output stage 21 could be located in peripheral circuitry located, for instance, at the edge of the array 80.

The array 80 may also comprise at least one calibration pixel, with a capacitance of e.g. a known capacitance value and/or known behavior, and connected to an calibration oscillator circuit 10, which may be used to calibrate the sensing results for the input-controlled oscillator circuits 10 of the actual array pixels 81.

Fig. 8(b) illustrates another option to calibrate the circuit, wherein a small cap Cₒ of known capacitance value is used near the oscillator circuit 10. First, the known capacitance value Cₒ is measured, then calibrated, then the electrode element 11 (denoted as C₁ in FIG. 8(b)) is measured. This second option may provide benefits in the sense that each circuit can be calibrated individually. The option of Fig. 8(a) has benefits in the sense that only one extra pixel is needed, and therefore a very compact solution for calibration is achieved.

Based on an output voltage of the oscillator circuit 10, the EWOD array 80 (e.g. a controller for the array 80) can determine at least one of: a capacitance or a capacitance change of the electrode element, in dependence of a presence or not of a droplet 22 between the electrode pair 11a, 11b; a position of the droplet 22 on the array 80; a volume of the droplet 22 between the electrode pair 11a, 11b; a liquid composition of the droplet 22 between the electrode pair 11a, 11b; a malfunction of the electrode element 11.

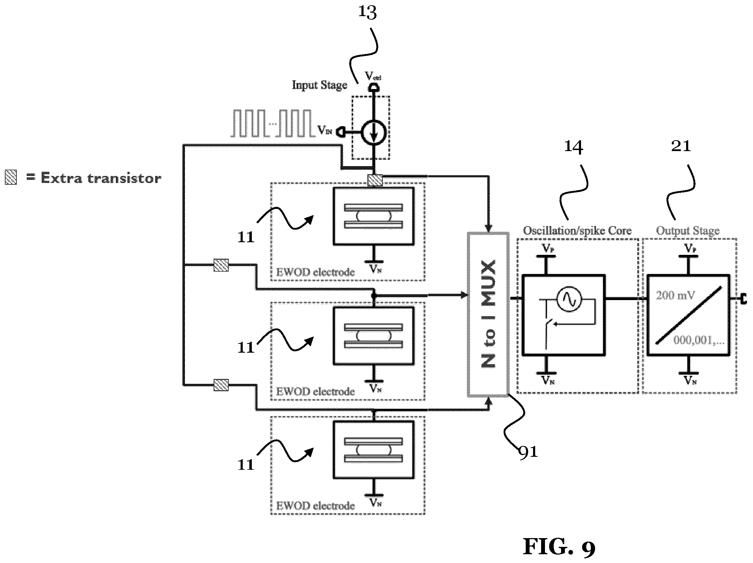

FIG. 9 illustrates a multiplexing example for an EWOD array with multiple electrode elements 11 and including at least one input-controlled oscillator circuit 10 according to this disclosure. The oscillator circuit 10 is in this example connected via a multiplexer 91 to multiple electrode elements 11. The multiplexer 91 is an N to 1 multiplexer, wherein N is the number of electrode elements 11 it is connected to, and may e.g. be 2, 3, 4, or any larger integer. The multiplexer 91 is arranged between the electrode elements 11 and the oscillator core circuit 14. The input stage 13 is connected to the electrode elements 11. The multiplexer 91 is independent and has only one function (electrode sharing). Optionally, extra transistors can be added as indicated in FIG. 9. With these transistors, it is possible to select how many electrode elements 11 are sensed at the same time. For example, 1, 2, 3, or more electrode elements 11 may be connected to the oscillator circuit 10 at the same time, or any given electrode element 11 may be individually connected.

Notably, the placement of the electrode elements 11 as illustrated is exemplary, and the placement is flexible. For instance, the electrode elements 11 may be arranged in row patches (e.g., 4x1 in case of four electrode elements 11), column patches (e.g., 1x4), or both (e.g., 2x2).

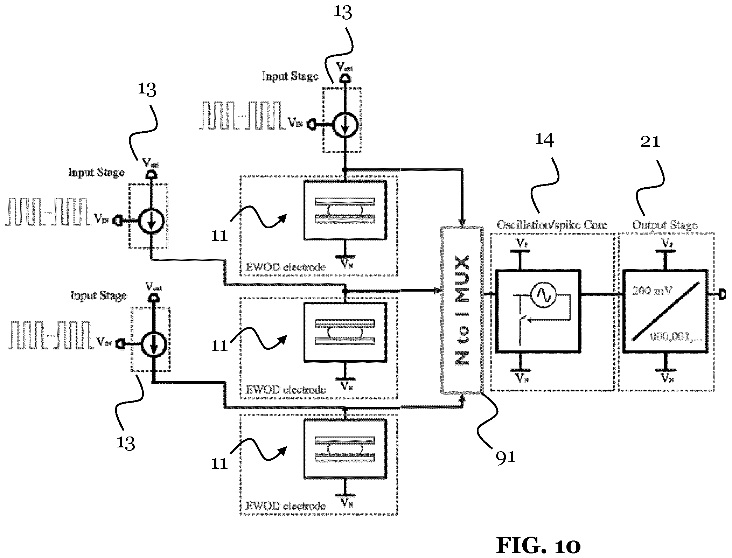

Another solution is to have dedicated input stages 13 per electrode element 11, as shown in FIG. 10. Otherwise, the multiplexing example shown in FIG. 10 is like the one described regarding FIG. 9.

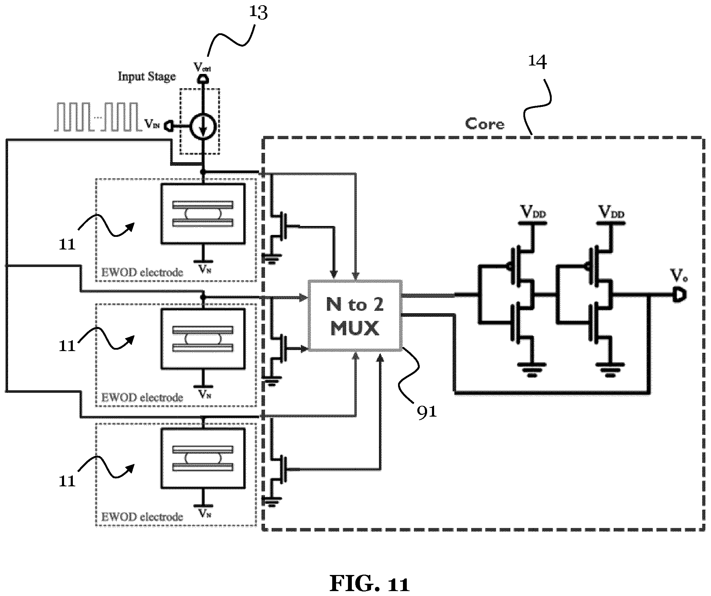

FIG. 11 illustrates another multiplexing example for an EWOD array with multiple electrode elements 11 and with at least one input-controlled oscillator circuit 10 according to this disclosure. In this example, the multiplexer is an N to 2 multiplexer, and is present inside the oscillator core circuit 14, for instance, it may be part of a loop in the oscillator core circuit 14. It may also have a clock gating function. That is, the multiplexer serves two functions (power consumption and electrode sharing).

Notably, the placement of the electrode elements 11 as illustrated is again exemplary, and the placement is flexible. For instance, the electrode elements 11 may again be arranged in row patches (e.g., 4x1 in case of four electrode elements 11), column patches (e.g., 1x4), or both (e.g., 2x2).

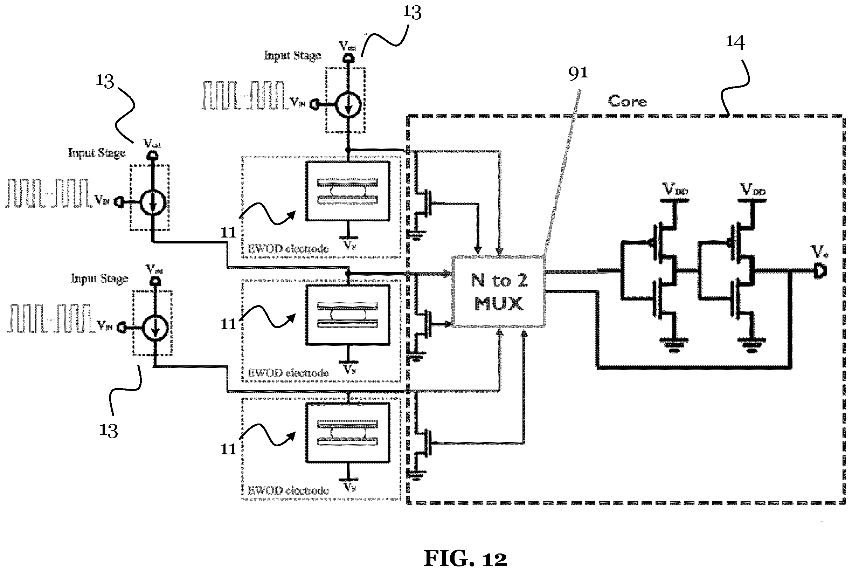

Another solution is again to have dedicated input stages 13 per electrode element 11, as shown in FIG. 12. Otherwise, the multiplexing example shown in FIG. 12 is like the one described regarding FIG. 11.

In summary, this disclosure provides an input-controlled oscillator circuit 10 for sensing the capacitance value(s) of one or more EWOD electrode elements 11. The oscillator circuit 10 may be simple of design, e.g. may be a 6-element circuit (e.g., 5 transistors and 1 extra element that can be either a transistor or a resistor). The oscillator circuit 10 may transforms a change in capacitance value of the electrode element 11 into a change in frequency. The frequency can be adjusted with a control voltage or current. The frequency may also be turned into something else to be easily readable on a large array (ex. frequency into output voltage, or frequency into a digital number or word).

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. An input-controlled oscillator circuit (10) for sensing a capacitance of an electrode element (11), the electrode element (11) being suitable for an electrowetting on dielectric, EWOD, array (80) for droplet manipulation,
wherein the electrode element (11) comprises a pair of electrodes (11a, 11b), and a node (12) of the input-controlled oscillator (10) is connectable to a first electrode (11a) of the electrode pair (11); and
wherein the input-controlled oscillator circuit (10) comprises:
an input stage (13) connected to the node (12), and configured to provide a current or current pulse for charging the first electrode (11a) based on a received control input (16);
an oscillator core circuit (14) connected to the node (12), and configured to cyclically discharge the first electrode (11a), thereby generating an oscillation with an oscillation frequency that depends on the capacitance of the electrode element (11);
wherein the oscillator core circuit (14) is further configured to produce a voltage signal at an output node (15) of the oscillator core circuit (14), based on a capacitance value of the electrode element (11) and the control input (16) shifting the oscillation frequency.

2. The input-controlled oscillator circuit (10) according to claim 1, wherein
the voltage signal at the output node (15) is a voltage spike indicative of the capacitance value of the electrode element (11).

3. The input-controlled oscillator circuit (10) according to claim 1 or 2, wherein
the capacitance value of the electrode element (11) is caused by the appearance or disappearance of a droplet (22) between the electrode pair (11a, 11b) or by a change in the nature of liquid between the electrode pair (11a, 11b).

4. The input-controlled oscillator circuit (10) according to one of the claims 1 to 3, wherein
the input stage (13) comprises a first transistor (31);
the first transistor (31) being arranged to receive the control input (16) at a first source/drain, SD, terminal, and to provide the current from a second SD terminal, which is connected to the node (12) and to a gate terminal of the transistor (31).

5. The input-controlled oscillator circuit (10) according to claim 4, further comprising
a second transistor (41) connected between the node (12) and the reference voltage, and connected with its gate terminal to the output node (15) of the oscillator core circuit (14).

6. The input-controlled oscillator circuit (10) according to claim 5, further comprising
a switch (42) arranged between the gate terminal of the second transistor (41) and the output node (15) of the oscillator core circuit (14);
wherein the switch (42) is configured to selectively disconnect the gate terminal of the second transistor (41) from the output node (15) of the oscillator circuit (14).

7. The input-controlled oscillator circuit (10) according to one of the claims 1 to 3, wherein
the input stage (13) comprises a resistor (32) connected to a first SD terminal of a first transistor (33);
the resistor (32) being arranged to receive the control input (16); and
the first transistor (33) being arranged to provide the current pulse via its second SD terminal, which is connected to the node (12), in response to a varying voltage (34) provided to a gate terminal of the first transistor (33).

8. The input-controlled oscillator circuit (10) according to claim 7, further comprising
a buffer circuit (43) connected between the node (12) and the oscillator core circuit (14).

9. The input-controlled oscillator circuit (10) according to one of the claims 1 to 8, wherein
the oscillator core circuit (14) comprises two or more consecutively connected oscillation stages (44), the connected oscillation stages (44) forming an oscillator.

10. The input-controlled oscillator circuit (10) according to claim 9, wherein each oscillator stage (44) comprises a transistor pair;
the two transistors of the transistor pair being connected in series between a supply voltage and the reference voltage; and
gate terminals of the two transistors being connected together and connected to either the node (12) or to the transistor pair of the previous oscillator stage (44).

11. The input-controlled oscillator circuit (10) according to claim 9 or 10, wherein the oscillator core circuit (14) further comprises:
one or more power gating transistors (51) connecting, respectively, one or more of the oscillation stages (44) to a supply voltage; or
one or more clock gating transistors (52), each clock gating transistor (52) being connected between two consecutive oscillation stages (44) or between the oscillator core circuit (14) and the node (12).

12. The input-controlled oscillator circuit (10) according to one of the claims 1 to 11, further comprising:
an analog output stage (21, 21a) connected to the output node (15) of the oscillator core circuit (14);
wherein the analog output stage (21, 21a) is configured to convert the voltage signal at the output node (15) into a voltage discharge or charge signal;
a slope or an absolute value of the voltage discharge or charge signal being indicative of the capacitance of the electrode element (11).

13. The input-controlled oscillator circuit (10) according to one of the claims 1 to 12, further comprising:
a digital counter (21, 21b) connected to the output node (15) of the oscillator core circuit (14);
wherein the digital counter (21b) is configured to count a number of voltage signals per predetermined time period at the output node (15), and to output a digital word based on the counted number, which is indicative of the capacitance of the electrode element (11).

14. An electrowetting on dielectric, EWOD, array (80) for a microfluidics system, the EWOD array (80) being configured to manipulate one or more droplets (22) by electrowetting and comprising:
a plurality of pixels (81), each pixel (81) comprising an electrode element (11);
one or more input-controlled oscillator circuits (10) respectively according to one of the claims 1 to 13;
wherein each input-controlled oscillator circuit (10) is connected to an electrode element (11) of at least one pixel (81).

15. The EWOD array (80) according to claim 14, configured to, based on an output of the oscillator circuit (10), determine at least one of:
a capacitance or a capacitance change of the electrode element (11), in dependence of a presence or not of a droplet (22) between the electrode pair (11a, 11b);
a position of the droplet (22) between the electrode pair (11a, 11b);
a volume of the droplet (22) between the electrode pair (11a, 11b);
a liquid composition of the droplet (22) between the electrode pair (11a, 11b);
a malfunction of the electrode element (11).
